# EUROPEAN PATENT SPECIFICATION

(11) **EP 3 977 528 B1**
(45) Date of publication and mention of the grant of the patent: **19.07.2023**
(21) Application number: 20744147.8
(22) Date of filing: 21.05.2020
(51) Int. Cl.: H10N 70/00

(54) **QUANTUM DIODE FOR TRANSFORMING AN ALTERNATING CURRENT, IN PARTICULAR HIGH FREQUENCY ALTERNATING CURRENT, INTO A DIRECT CURRENT**
QUANTENDIODE ZUR UMWANDLUNG VON WECHSELSTROM, INSBESONDERE HOCHFREQUENTEM WECHSELSTROM, IN GLEICHSTROM
DIODE QUANTIQUE POUR TRANSFORMER UN COURANT ALTERNATIF, EN PARTICULIER UN COURANT ALTERNATIF HAUTE FRÉQUENCE, EN COURANT CONTINU

(30) Priority: 30.05.2019 IT 201900007572
(43) Date of publication of application: 06.04.2022
(73) Proprietor: GREEN ARISE LTD, Nicosia (CY)
(72) Inventor: PASQUALI, Cesare Maria Mose, 61048 Sant'angelo in Vado (PU) (IT)
(74) Representative: Ferriero, Paolo
(86) International application number: PCT/IT2020/050130
(87) International publication number: WO 2020/240603

(56) References cited:
- EP-A2- 0 271 291
- WO-A2-2010/144127
- US-A1- 2008 105 870
- US-A1- 2010 289 005

## Description

The present invention refers to a quantumdiode for transforming an alternating current, in particular a high frequency alternating current, into a direct current.

Particularly, the invention reates to the structur of said quantum diode configured to allow said diode to operate up to the frequencies belonging to the THz band and to have a high switching speed.

The operation of said quantum diode is based on the movement of a quantity of electrons which by tunnel effect moves from a first electrode to a second electrode of said quantum diode, jumping an electrically insulating layer.

### Prior art

Currently, they are known diodes for transforming an alternating current into a direct current.

An example of a diode for rectifying an alternating current into a direct current is the Schottky diode which includes a metal - semiconductor junction.

A disadvantage of said diode is that said junction implies that the electrons physically cross a dielectric layer, so that a quantity of energy is absorbed by the junction itself, with a consequent heating of the diode itself.

However, the Schottky diode is not a quantum diode.

A first example of quantum diode is a MIM diode, i.e. a metal-insulating-metal type diode.

A disadvantage of this MIM diode is due to the complexity of the structure and to the difficulty of production.

A second example of a quantum diode is a MIIM diode, i.e. a metal-insulating-insulating-metal type diode.

A disadvantage of this MIIM diode is that a greater polarization than the MIM diode is rnecessary to allow the electrons to jump over two insulating layers.

Consequently, a power supply unit is required.

Like the MIM diode, a further disadvantage is due to the complexity of the structure and to the difficulty of production.

### Aim of the invention

Aim of the present invention is to overcome said disadvantages by providing a quantum diode to transform an alternating current, in particular a high frequency alternating current, into a direct current, capable of operating up to frequencies of the THz band and having a high switching capacity.

In fact, the structure of the quantum diode, object of the invention, is designed to allow the quantum diode itself to transform an alternating current with a frequency in the THz band into a direct current.

A second aim of the present invention is to provide a quantum diode having a simple structure and a low production cost.

A further aim of the present invention is to provide a quantum diode which does not heat up and has a higher efficiency than a junction diode, since said quantum diode dissipates a quantity of heat and an irrelevant amount of energy with respect to said junction diode.

WO 2010/144127 A, US 2008/0105870 A1 and US 2010/0289005 A1 all show tunneling devices of the metal-insulating-metal type with different detail configurations and thicknesses of the insulating layer.

### Object of the invention

It is therefore object of the invention a quantum diode for transforming an alternating current, in particular a high frequency alternating current, into a direct current, comprising:
o a first conductive metal layer, where said first conductive metal layer behaves as a first electrode or cathode of said quantum diode and comprises a first surface and a second surface, opposite to the first surface, a third surface joining said first surface and said second surface, where said third surface contacts said first surface at a first contact line in such a way that said third surface and said first surface form a first angle greater than or equal to 90 ° and less than 180°,
o an electrically insulating layer having a first end and a second end and comprising a first portion and a second portion,
   where
   said first portion at least partially contacts said third surface of said first conductive metal layer and is parallel to said third surface, and said second portion contacts a portion of the first surface of said first conductive metal layer and is parallel to said portion of said first surface,
   said first portion and said second portion are arranged so as to form an angle equal to said first angle,
o a second conductive metal layer having a first end and a second end and comprising a first portion and a second portion,
   where
   said first portion contacts the first portion of said electrically insulating layer and is parallel to said first portion, and said second portion at least partially contacts the second portion of said electrically insulating layer and is parallel to said second portion,
   said first portion and said second portion are arranged so as to form an angle equal to said first angle,
o a third conductive metal layer behaving as a second electrode or anode, where said third conductive metal layer at least partially contacts the first portion and the second portion of said second conductive metal layer and is electrically isolated from said first conductive metal layer.

In particular, said first conductive metal layer is made of a first metallic material, said second conductive metal layer is made of a second metal material, different from said first metallic material, and said first conductive metal layer and said second conductive metal layer are separated by said electrically insulating layer and the thickness of said electrically insulating layer is between 1,5nm and 5nm, so that, when in use, a quantity of electrons moves from said first conductive metal layer to said second conductive metal layer, jumping, by tunnel effect, said electrically insulating layer at said first contact line.

With reference to the first conductive metal layer, said first conductive metal layer can be made of gold.

With reference to the second conductive metal layer, said second conductive metal layer can be made of chrome.

Furthermore, said first conductive metal layer and said third conductive metal layer can be made of the same metallic material.

It is preferable that said first conductive metal layer has a thickness greater than the thickness of said second conductive metal layer.

In particular, said first conductive metal layer can have a thickness between 50nm and 100nm, preferably 50nm.

Said second conductive metal layer can have a thickness between 10nm and 30nm, preferably 10nm.

Furthermore, said third conductive metal layer can have a thickness between 50nm and 100nm, preferably 50nm.

With reference to the electrically insulating layer, said electrically insulating layer can be made of dialuminium trioxide or hafnium dioxide or gallium.

Said third conductive metal layer can comprise a first portion and a second portion.

The first portion of said third conductive metal layer at least partially contacts the first portion of said second conductive metal layer and is parallel to the latter, and the second portion of said third conductive metal layer at least partially contacts the second portion of said second conductive metal layer and is parallel to to the latter. The first portion and the second portion are arranged so as to form an angle equal to said first angle.

In a first alternative, said quantum diode can comprise a dielectric layer comprising a first surface, and said first conductive metal layer is arranged on a portion of said first surface of said first dielectric layer. Furthermore, the first end of said electrically insulating layer, the first end of said second conductive metal layer and a portion of said third conductive metal layer can contact said first surface of said dielectric layer.

In a second alternative, said quantum diode can comprise a dielectric layer comprising a first surface, and a further conductive metal layer, arranged between said first conductive metal layer and said dielectric layer, where said further metal layer is made of a further metallic material, different from the first metallic material of said first conductive metal layer. Furthermore, said further conductive metal layer comprises a first surface and a second surface, opposite to said first surface. The first surface of said further conductive metal layer can contact at least a portion of said second surface of the first conductive metal layer, as well as the first end of said electrically insulating layer, the first end of said second conductive metal layer and a portion of the third conductive metal layer. The second surface at least partially can contact the first surface of said dielectric layer.

It is preferable that said further conductive metal layer is made of chrome.

Furthermore, said further conductive metal layer can have a thickness between 10nm and 30nm, preferably 10nm.

### Figure list

The present invention will be now described, for illustrative, but not limitative purposes, according to its embodiment, making particular reference to the enclosed figures, wherein:
Figure 1 is a schematic cross-sectional view of the quantum diode, object of the invention;
Figure 2 is an exploded schematic view of the quantum diode of Figure 1;
Figure 3 is a schematic view showing only some layers of the quantum diode.

### Detailed description

Everywhere in this description and in the claims the case where the term "comprises" is replaced by the term "consists of" is included.

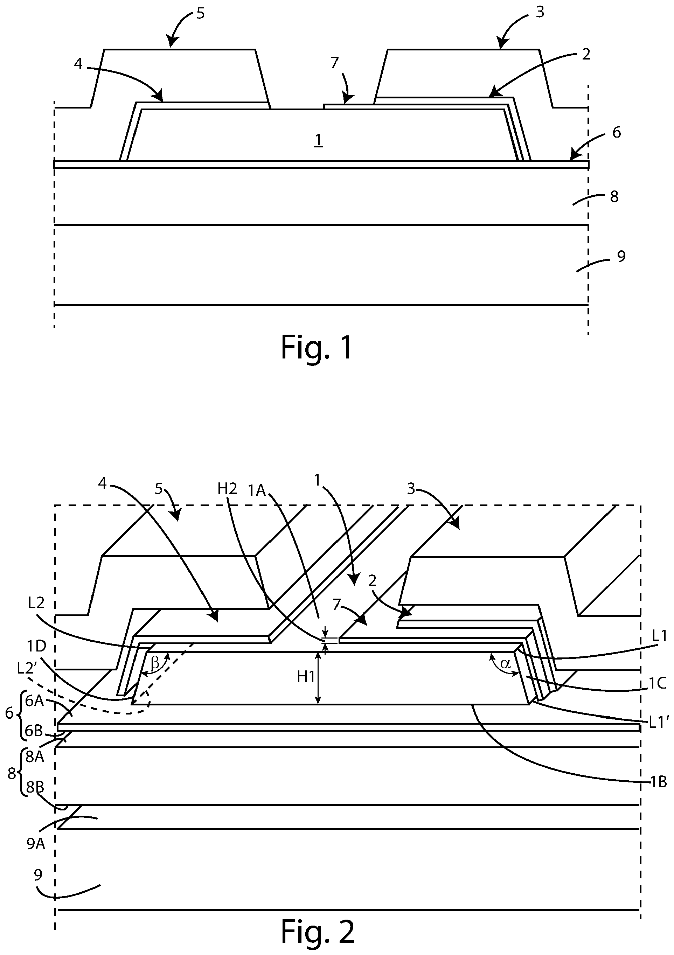

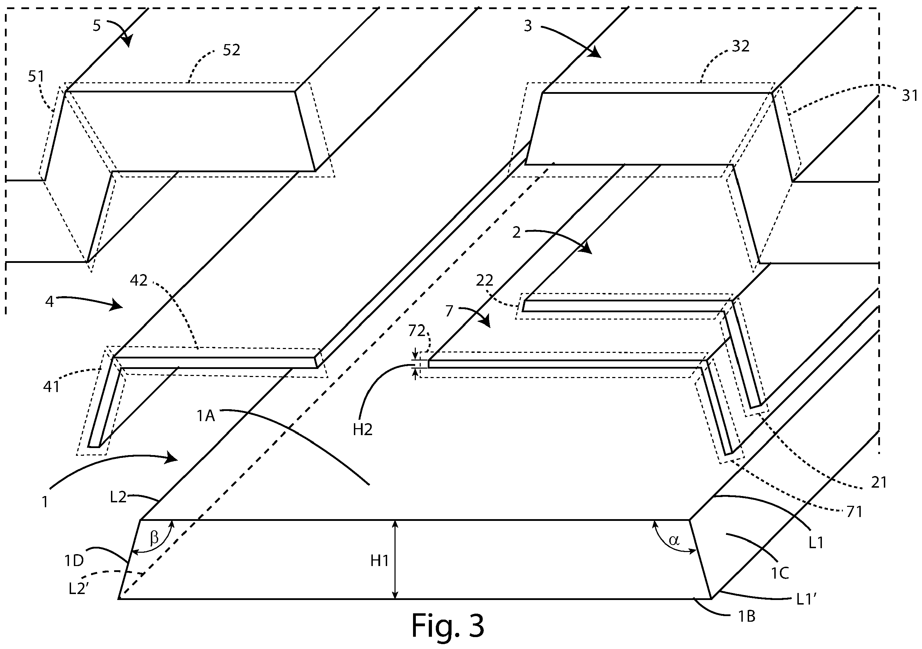

With reference to the Figures 1-3, a quantum diode for transforming an alternating current, in particular a high frequency alternating current, into a direct current.

Said quantum diode comprises:
o a first conductive metal layer 1, where said first conductive metal layer 1 behaves as a first electrode or cathode of said quantum and comprises a first surface 1A, a second surface 1B, opposite to the first surface 1A, and a third surface 1C (arranged between said first surface 1A and said second surface 1B) joining said first surface 1A and said second surface 1B, where said thierd surface 1C contats said first surface 1A at a first contact line L1 in such a way that said first surface 1A and said third surface 1C form (each other) a first angle α greater or equal to 90° and less than 180°,
o an electrically insulating layer 7 having a first end and a second end and comprising:
   ▪ a first portion 71, and
   ▪ a second portion 72,
      where
      said first portion 71 at least partially contacts said third surface 1C of said first conductive metal layer 1 and is parallel to said third surface 1C, and
      said second portion 72 contacts a portion of the first surface 1A of said first conductive metal layer 1 and is parallel to said portion of said first surface 1A,
o a second conductive metal layer 2 having a first end and a second end and comprising:
   ▪ a first portion 21, and
   ▪ a second portion 22,
      where
      said first portion 21 at least partially contacts the first portion 71 of said electrically insulating layer 7 and is parallel to said first portion 71, and
      said second portion 22 at least partially contacts the second portion 72 of said electrically insulating layer 7 and is parallel to said second portion 72,
   o a third conductive metal layer 3 behaving as a second electrode or anode, where said third conductive metal layer 3 at least partially contacts the first portion 21 and the second portion 22 of said second conductive metal layer 2 and is electrically isolated from said first conductive metal layer 1 (by means of said electrically insulating layer 7).

With reference to the first conductive metal layer 1 and to the second conductive metal layer 2, each of said layers is made of a respective metal material.

In particular, said first conductive metal layer 1 is made of a first metal material and said second conductive metal layer 2 is made of a second metal material, different from said first metal material.

The fact that the metallic material with which the first conductive metal layer 1 is made is different from the metal material with which the second conductive metal layer 2 is made implies an "asymmetry" in the structure of the quantum diode allowing the quantum diode to rectify at high speed the alternating current in a direct current.

Furthermore, said first conductive metal layer 1 and said second conductive metal layer 2 are separated from said electrically insulating layer 7 and the thickness of said electrically insulating layer 7 is between 1,5nm and 5nm (preferable 2nm, as said below).

The fact that the thickness of said electrically insulating layer 7 is so reduced facilitates the jump of electrons from the first conductive metallic layer 1 to the second conductive metallic layer 2, preventing the electrons, having reached the second conductive metallic layer 2, from returning to the first metallic layer conductor 1.

The thickness dimensions of the electrically insulating layer 7 above mentioned, on the one hand, avoid the risk of short circuit between the first conductive metallic layer 1 and the second conductive metallic layer 2 and, on the other side, ensure that the electrons reach the second layer metallic conductor 2.

In fact, said quantum diode is configured to transform an alternating current into a direct current through a jump of electrons from the first conductive metal layer 1 to the second conductive metal layer 2, by tunnel effect, at said first contact line L1, so that the electrically insulating layer 7 (arranged between said first conductive metal layer 1 and said second conductive metal layer 2) is jumped by said electrons.

In fact, when the quantum diode is in use, a quantity of electrons moves from the first conductive metal layer 1 to the second conductive metal layer 2, jumping, by tunnel effect, the electrically insulating layer 7 at the first contact line L1.

With reference to the first conductive metal layer 1, the third surface 1C contacts said second surface 1B at a further first contact line L1'.

Furthermore, said first conductive metal layer 1 comprises a fourth surface 1D (arranged between said first surface 1A and said second surface 1B), facing said third surface 1C, which joins said first surface 1A and said second surface 1B, where said fourth surface 1D contacts said first surface 1A at a second contact line L2 in such a way that said first surface 1A and said fourth surface 1D form (each other) a second angle β greater than or equal to 90 ° and less than 180°.

In fact, said fourth surface 1D and said first surface 1A are arranged in such a way as to form said second angle β which, in the embodiment being described, is equal to the first angle α.

Said fourth surface 1D contacts not only said first surface 1A but also said second surface 1B.

In particular, said fourth 1D contacts said second surface 1B at a further second contact line L2'.

With reference to the cross section of the first conductive metal layer 1, said first conductive metal layer 1 has a first height H1.

Furthermore, in cross-section, said first conductive metal layer 1 has the shape of an isosceles trapezoid.

With reference to the second conductive metal layer 2, the first portion 21 and the second portion 22 are arranged in such a way as to form an angle equal to said first angle α.

In cross section said second conductive metal layer 2 has a second height H2, less than said first height H1.

In other words, the thickness of the first conductive metal layer 1 is greater than the thickness of the second conductive metal layer 2.

So, with reference to the structure of the quantum diode, the fact that the first conductive metal layer 1 and the second conductive metal layer 2 have different thicknesses (i.e. different heights) contributes to the "asymmetry" of the structure of the quantum diode allowing the quantum diode to rectify the alternating current into a direct current at a higher speed.

The thickness of the first conductive metal layer 1 can be between 50nm and 100nm, preferably 50nm.

The thickness of the second conductive metal layer 2 can be between 10nm and 30nm, preferably 10nm.

In the embodiment being described, the first metal conductive layer is preferable made of gold.

In particular, the first conductive metal layer 1 and the third conductive metal layer 3 are made of the same metal material, preferable gold.

In the embodiment being described, the third metal conductive layer 3, seen in cross section, has the same height as the first conductive metal layer 1.

In other words, said first conductive metal layer 1 and said third conductive metal layer 3 has the same thickness.

Therefore also the thickness of the third conductive metal layer 3 can be between 50nm and 100nm, preferably 50nm.

In the embodiment being described, said second conductive metal layer 2 is preferably made of chromium.

With reference to the electrically insulating layer 7, the first portion 71 and the second portion 72 are arranged in such a way as to form an angle equal to said first angle α.

In particular, said electrically insulating layer 7 is preferable made of dialuminium trioxide (Al₂O₃).

The thickness of said electrically insulating layer 7 is less than the thickness of the second conductive metal layer 2.

As already said, in fact, the thickness of said electrically insulating layer 7 can be between 1,5nm e 5nm, preferable 2nm.

Alternatively, said electrically insulating layer 7 can be made of hafnium dioxide (HfO₂) or gallium (Ga), without thereby departing from the scope of the invention

With reference to the third conductive metal layer 3, said third conductive metal layer 3 has a first end and a second end and comprises:
- a first portion 31,
- a second portion 32.

Said first portion 31 at least partially contacts the first portion 21 of the second conductive metal layer 2 and is parallel to said first portion 21 and said second portion 32 at least partially contacts the second portion 22 of the second conductive metal layer 2 and is parallel to said second portion 22.

The first portion 31 and the second portion 32 of the third conductive metal layer 3 are arranged in such a way as to form an angle equal to said first angle α.

Furthernore, in the embodiment being described, sai quantum diode comprises a fourth conductive metal layer 4 and a fifth conductive metal layer 5

However, said fourth conductive metal layer 4 and said fifth conductive metal layer 5 are not necessary.

With reference to the fourth conductive metal layer 4, said fourth conductive metal layer 4 has a first end and a second end and comprises:
▪ a first portion 41, and
▪ a second portion 42.

Said first portion 41 at least partially contacts the fourth surface 1D of the first conductive metal layer 1 and is parallel to said fourth surface 1D.

Said second portion 42 at least partially contacts a further portion of the first surface 1A of said first conductive metal layer 1 and is parallel to said further portion (where said further protion of the first surface 1A is different from the portion of the first surface 1A being in contact with the second portion 72 of the electrically insulating layer 7)

The fifth conductive metal layer 5 at least partially contacts both said first portion 41 and said second portion 42 of said fourth conductive metallic layer 4.

With reference to the quantum diode, as already said, the fourth surface 1D of the first conductive metal layer 1 contacts the first surface 1A belonging to the same first conductive metal layer 1, at said second contact line L2 in such a way that said fourth surface 1D anda said first surface 1A form (each other) a second angle β greater than 90 ° and less than 180°.

Furthermore, the first portion 41 of the fourth conductive metal layer 4 and the second portion 42 of the same fourth conductive metal layer 4 are arranged in such a way as to form an angle equal to said second angle β.

With reference to the fifth conductive metal layer 5, as shown in the Figures, said fifth conductive metal layer 5 is at a predetermined distance from the third conductive metal layer 3 to avoid the short circuit between said conductive metal layers. Consequently, the third conductive metal layer 3 and the fifth conductive metal layer 5 are not in contact with each other.

In particular, the fifth conductive metal layer 5 comprises:
▪ a first portion 51 contacting at least partially the first portion 41 of the fourth conductive metal layer 4 and is parallel to said first portion 41,
▪ a second portion 52 contacting at least partially the second portion 42 of said fourth conductive metal layer 4 and is parallel to said second portion 42.

The first portion 51 and the second portion 52 are arranged between in such a way as to form an angle equal to said second angle β.

In the embodiment being described, said second conductive metal layer 2 and said fourth conductive metal layer 4 have the same thickness and are made of the same metal material, preferable chrome.

Furthermore, the second portion 72 of the electrically insulating layer 7 and the second portion 42 of the fourth conductive metal layer 4 are substantially coplanar.

In the embodiment being described, said quantum diode diode comprises:
o a dielectric layer 8 comprising a first surface 8A,
o a further conductive metal layer 6, arranged between said first conductive metal layer 1 and said dielectric layer 8

With reference to the dielectric layer, said dielectric layer 8 serve as "thermal plane" (capable of collecting thermal energy) and has a thickness based on the frequency of the alternating current to be transformed into direct current.

In particular, said dielectric layer 8 also comprises a second surface 8B, opposite to said first surface 8A.

With reference to the further conductive metal layer 6, said further conductive metal layer 6 comprises a first surface 6A and a second surface 6B, opposite to said first surface 6A.

Said first surface 6A at least partially contacts a portion of the second surface 1B of the first conductive metal layer 1, as well as the first end of the first portion 71 of said electrically insulating layer 7, the first end of the first portion 21 of said second conductive metal layer 2 and a portion of the third conductive metal layer 3.

Furtermore, in the embodiment being described, said first surface 6A also contacts the first end of the first portion 41 of the fourth conductive metal layer 4 and a portion of the fifth conductive layer 5.

Said second surface 6B at least partially contacts the first surface 8A of said dielectric layer 8.

In the embodiment being described, said further conductive metal layer 6 is made of a further metal material, different from the first metal material of the first conductive metal layer 1, so as to contribute to the "asymmetry" of the structure of the quantum diode.

In particular, in the embodiment being described, said further conductive metal layer 6 is made of chrome.

However, said further conductive metal layer 6 is not necessary.

In fact, on the basis of the metallic material that is chosen to make the first conductive metallic layer 1, it is not necessary for the quantum diode to comprise in addition to the dielectric layer 8 also said further conductive metallic layer 6.

Hence, in a variant of the quantum diode in which said further conductive metallic layer 6 is not present, the first conductive metallic layer 1 is arranged directly on a portion of the first surface 8A of the dielectric layer 8.

In this variant, the first end of the first portion 71 of the electrically insulating layer 7, the first end of the first portion 21 of said second conductive metallic layer 2 and a portion of said third conductive metallic layer 3 contact the first surface 8A of the dielectric layer 8 .

Furthermore, the first end of the first portion 41 of the fourth conductive metal layer 4 and a portion of the fifth conductive metal layer 5 contact the first surface 8A of said dielectric layer 8.

Either in the case where the quantum diode comprises the dielectric layer 8 and the further conductive metal layer 6 or only the dielectric layer 8 (without therefore the need for the further conductive metal layer 6 to be present in the structure of the quantum diode), said dielectric layer 8 is made of silicon dioxide (SiO2) and has a thickness of between 50nm and 300nm, preferably 300nm, based on the frequency of the alternating current to be transformed into direct current.

Said further conductive metal layer 6 can have a thickness between 10nm and 30nm, preferably 10nm.

The thickness dimensions of the further conductive metallic layer 6 allow said further conductive metallic layer 6 to function as a reinforcement layer for the first conductive metallic layer 1 and allow the first conductive metallic layer 1 to have greater stability with respect to the dielectric layer 8.

Furthermore, the quantum diode comprises a support layer 9.

Said support layer 9 comprises a first surface 9A, arranged in contact with the second surface 8B of the dielectric layer 8.

Said support layer 9 is made of a material selected from the following group: ceramic, polycarbonate, polyethylene, polyester fabric, cycloolefin copolymers, preferably Topas.

Finally, the fact that the portions of different layers in contact with each other are parallel reduces the dispersion of electrons.

### Advantages

Advantageously, as already mentioned, the quantum diode, object of the invention, allows to transform an alternating current (in particular a high frequency alternating current) in a direct current, where said alternating current can be generated for example by an electromagnetic wave picked up by an antenna to which said quantum diode is connected.

A second advantage is given by the fact that said quantum diode is capable of operating also at frequencies in the THz band.

A third advantage is given by the fact that said quantum diode has a high switching speed which allows the quantum diode itself to be used in different electronic devices/systems, for example in an antenna configured to resonate with the electromagnetic waves picked up by said antenna or in optical devices/systems configured to work in the infrared or in transmission devices/systems to transmit data at high speed, for civil or military use, or in a computer to encode information.

A fourth advantage is given by the fact that said quantum diode produces a greater quantity of energy compared to a junction diode since the quantity of electrons dispersed after jumping the electrically insulating layer is limited.

A further advantage is given by the fact that said quantum diode does not heat up and dissipate in terms of heat and energy irrelevant quantities compared to a junction diode.

The present invention has been described for illustrative, but not limitative purposes, according to its preferred embodiment, but it is to be understood that variations and/or modifications can be carried out by a skilled in the art, without departing from the scope thereof, as defined according to enclosed claims.

## Claims

1. Quantum diode for transforming an alternating current, in particular a high frequency alternating current, into a direct current, comprising:
o a first conductive metal layer (1), where said first conductive metal layer (1) behaves as a first electrode or cathode of said quantum diode and comprises a first surface (1A) and a second surface (1B), opposite to the first surface (1A), a third surface (1C) joining said first surface (1A) and said second surface (1B), where said third surface (1C) contacts said first surface (1A) at a first contact line (L1) in such a way that said third surface (1C) and said first surface (1A) form a first angle (α) greater than or equal to 90° and less than 180°,
o an electrically insulating layer (7) having a first end and a second end and comprising a first portion (71) and a second portion (72),
where
said first portion (71) at least partially contacts said third surface (1C) of said first conductive metal layer (1) and is parallel to said third surface (1C), and
said second portion (72) contacts a portion of the first surface (1A) of said first conductive metal layer (1) and is parallel to said portion of said first surface (1A),
said first portion (71) and said second portion (72) are arranged so as to form an angle equal to said first angle (α),
o a second conductive metal layer (2) having a first end and a second end and comprising a first portion (21) and a second portion (22),
where
said first portion (21) contacts the first portion (71) of said electrically insulating layer (7) and is parallel to said first portion (71), and
said second portion (22) at least partially contacts the second portion (72) of said electrically insulating layer (7) and is parallel to said second portion (72),
said first portion (21) and said second portion (22) are arranged so as to form an angle equal to said first angle (α),
o a third conductive metal layer (3) behaving as a second electrode or anode, where said third conductive metal layer (3) at least partially contacts the first portion (21) and the second portion (22) of said second conductive metal layer (2) and is electrically isolated from said first conductive metal layer (1),
where
said first conductive metal layer (1) is made of a first metallic material, said second conductive metal layer (2) is made of a second metal material, different from said first metallic material,
said first conductive metal layer (1) and said second conductive metal layer (2) are separated by said electrically insulating layer (7) and the thickness of said electrically insulating layer (7) is between 1.5nm and 5nm,
so that, when in use, a quantity of electrons moves from said first conductive metal layer (1) to said second conductive metal layer (2), jumping, by tunnel effect, said electrically insulating layer (7) at said first contact line (L1).

2. Quantum diode according to the previous claim, **characterized in that** said first conductive metal layer (1) is made of gold.

3. Quantum diode according to any one of the previous claims, **characterized in that** said second conductive metal layer (2) is made of chrome.

4. Quantum diode according to any one of the previous claims, **characterized in that** said first conductive metal layer (1) and said third conductive metal layer (3) are made of the same metallic material.

5. Quantum diode according to any one of the previous claims, **characterized in that** said first conductive metal layer (1) has a thickness greater than the thickness of said second conductive metal layer (2).

6. Quantum diode according to any one of the previous claims, **characterized in that** said first conductive metal layer (1) has a thickness between 50nm and 100nm, preferably 50nm.

7. Quantum diode according to any one of the previous claims, **characterized in that** said second conductive metal layer (2) has a thickness between 10nm and 30nm, preferably 10nm.

8. Quantum diode according to any one of the previous claims, **characterized in that** said third conductive metal layer (3) has a thickness between 50nm and 100nm, preferably 50nm.

9. Quantum diode according to any one of the previous claims, **characterized in that** said electrically insulating layer (7) is made of dialuminium trioxide or hafnium dioxide or gallium.

10. Quantum diode according to any one of the previous claims, **characterized in that** said third conductive metal layer (3) comprises:
- a first portion (31),
- a second portion (32),
where
said first portion (31) at least partially contacts the first portion (21) of said second conductive metal layer (2) and is parallel to said first portion (21), and
said second portion (32) at least partially contacts the second portion (22) of said second conductive metal layer (2) and is parallel to said second portion (22),
said first portion (31) and said second portion (32) are arranged so as to form an angle equal to said first angle (α).

11. Quantum diode according to any one of claims 1-10, **characterized**
**in that**
said quantum diode comprises:
o a dielectric layer (8) comprising a first surface (8A),
**in that**
said first conductive metal layer (1) is arranged on a portion of the first surface (8A) of said first dielectric layer (8),
**in that**
the first end of said electrically insulating layer (7), the first end of said second conductive metal layer (2) and a portion of said third conductive metal layer (3) contact said first surface (8A) of said dielectric layer (8).

12. Quantum diode according to any one of claims 1-10, **characterized**
**in that**
said quantum diode comprises:
o a dielectric layer (8) comprising a first surface (8A), and
o a further conductive metal layer (6), arranged between said first conductive metal layer (1) and said dielectric layer (8), where said further metal layer (6) is made of a further metallic material, different from the first metallic material of said first conductive metal layer (1),
**in that**
said further conductive metal layer (6) comprises a first surface (6A) and a second surface (6B), opposite to said first surface (6A),
where
said first surface (6A) contacts at least a portion of the second surface of said first conductive metal layer (1), as well as the first end of said electrically insulating layer (7), the first end of said second conductive metal layer (2) and a portion of the third conductive metal layer (3), and
said second surface (6B) at least partially contacts the first surface (8A) of said dielectric layer (8).

13. Quantum diode according to the previous claim, **characterized in that** said further conductive metal layer (6) is made of chrome.

14. Quantum diode according to claim 12 or 13, **characterized in that** said further conductive metal layer (6) has a thickness between 10nm and 30nm, preferably 10nm.

## Patentansprüche

1. Quantendiode zum Umwandeln eines Wechselstroms, insbesondere eines hochfrequenten Wechselstroms, in einen Gleichstrom, umfassend:
o eine erste leitende Metallschicht (1), wobei sich die erste leitende Metallschicht (1) als erste Elektrode oder Kathode der Quantendiode verhält und eine erste Oberfläche (1A) und eine zweite Oberfläche (1B) gegenüber der ersten Oberfläche (1A) umfasst, eine dritte Oberfläche (1C), die die erste Oberfläche (1A) und die zweite Oberfläche (1B) verbindet, wobei die dritte Oberfläche (1C) die erste Oberfläche (1A) auf eine Weise an einer ersten Kontaktlinie (L1) berührt, dass die dritte Oberfläche (1C) und die erste Oberfläche (1A) einen ersten Winkel (α) bilden, der größer als oder gleich wie 90° und kleiner als 180° ist,
o eine elektrisch isolierende Schicht (7), die ein erstes Ende und ein zweites Ende aufweist und umfassend einen ersten Abschnitt (71) und einen zweiten Abschnitt (72), wobei der erste Abschnitt (71) zumindest teilweise die dritte Oberfläche (1C) der ersten leitenden Metallschicht (1) berührt und parallel zu der dritten Oberfläche (1C) ist, und der zweite Abschnitt (72) einen Abschnitt der ersten Oberfläche (1A) der ersten leitenden Metallschicht (1) berührt und parallel zu diesem Abschnitt der ersten Oberfläche (1A) ist, der erste Abschnitt (71) und der zweite Abschnitt (72) angeordnet sind, um einen Winkel zu bilden, der gleich wie der erste Winkel (α) ist,
o eine zweite leitende Metallschicht (2), die ein erstes Ende und ein zweites Ende aufweist, umfassend einen ersten Abschnitt (21) und einen zweiten Abschnitt (22),
wobei der erste Abschnitt (21) den ersten Abschnitt (71) der elektrisch isolierenden Schicht (7) berührt und parallel zu diesem ersten Abschnitt (71) ist, und der zweite Abschnitt (22) den zweiten Abschnitt (72) der elektrisch isolierenden Schicht (7) zumindest teilweise berührt und parallel zu dem zweiten Abschnitt (72) ist, der erste Abschnitt (21) und der zweite Abschnitt (22) angeordnet sind, um einen Winkel zu bilden, der gleich wie der erste Winkel (α) ist,
o eine dritte leitende Metallschicht (3), die sich als zweite Elektrode oder Anode verhält, wobei die dritte leitende Metallschicht (3) zumindest teilweise den ersten Abschnitt (21) und den zweiten Abschnitt (22) der zweiten leitenden Metallschicht (2) berührt und von der ersten leitenden Metallschicht (1) elektrisch isoliert ist, wobei die erste leitende Metallschicht (1) aus einem ersten metallischen Werkstoff gefertigt ist, die zweite leitende Metallschicht (2) aus einem zweiten metallischen Material gefertigt ist, der sich von dem ersten metallischen Material unterscheidet, die erste leitende Metallschicht (1) und die zweite leitende Metallschicht (2) durch die elektrisch isolierende Schicht (7) getrennt sind und die Stärke der elektrisch isolierenden Schicht (7) zwischen 1,5 nm und 5 nm ist, sodass sich bei Verwendung eine Menge von Elektronen von der ersten leitenden Metallschicht (1) zu der zweiten leitenden Metallschicht (2) bewegt und durch Tunneleffekt die elektrisch isolierende Schicht (7) an der ersten Kontaktlinie (L1) überspringt.

2. Quantendiode nach dem vorherigen Anspruch, **dadurch gekennzeichnet, dass** die erste leitende Metallschicht (1) aus Gold gefertigt ist.

3. Quantendiode nach einem der vorherigen Ansprüche, **dadurch gekennzeichnet, dass** die zweite leitende Metallschicht (2) aus Chrom gefertigt ist.

4. Quantendiode nach einem der vorherigen Ansprüche, **dadurch gekennzeichnet, dass** die erste leitende Metallschicht (1) und die dritte leitende Metallschicht (3) aus demselben metallischen Material gefertigt sind.

5. Quantendiode nach einem der vorherigen Ansprüche, **dadurch gekennzeichnet, dass** die erste leitende Metallschicht (1) eine Stärke aufweist, die größer ist als die Stärke der zweiten leitenden Metallschicht (2) .

6. Quantendiode nach einem der vorherigen Ansprüche, **dadurch gekennzeichnet, dass** die erste leitende Metallschicht (1) eine Stärke zwischen 50 nm und 100 nm, vorzugsweise 50 nm, aufweist.

7. Quantendiode nach einem der vorherigen Ansprüche, **dadurch gekennzeichnet, dass** die zweite leitende Metallschicht (2) eine Stärke zwischen 10 nm und 30 nm, vorzugsweise 10 nm, aufweist.

8. Quantendiode nach einem der vorherigen Ansprüche, **dadurch gekennzeichnet, dass** die dritte leitende Metallschicht (3) eine Stärke zwischen 50 nm und 100 nm, vorzugsweise 50 nm, aufweist.

9. Quantendiode nach einem der vorherigen Ansprüche, **dadurch gekennzeichnet, dass** die elektrisch isolierende Schicht (7) aus Dialuminiumtrioxid oder Hafniumdioxid oder Gallium gefertigt ist.

10. Quantendiode nach einem der vorherigen Ansprüche, **dadurch gekennzeichnet, dass** die dritte leitende Metallschicht (3) Folgendes umfasst:
- einen ersten Abschnitt (31),
- einen zweiten Abschnitt (32),
wobei der erste Abschnitt (31) den ersten Abschnitt (21) der zweiten leitenden Metallschicht (2) zumindest teilweise berührt und parallel zu dem ersten Abschnitt (21) ist, und der zweite Abschnitt (32) den zweiten Abschnitt (22) der zweiten leitenden Metallschicht (2) zumindest teilweise berührt und parallel zu diesem zweiten Abschnitt (22) ist, der erste Abschnitt (31) und der zweite Abschnitt (32) angeordnet sind, um einen Winkel zu bilden, der gleich wie der erste Winkel (α) ist.

11. Quantendiode nach einem der Ansprüche 1 bis 10, **dadurch gekennzeichnet, dass** die Quantendiode Folgendes umfasst:
o eine dielektrische Schicht (8), umfassend eine erste Oberfläche (8A), dass die erste leitende Metallschicht (1) auf einem Abschnitt der ersten Oberfläche (8A) der ersten dielektrischen Schicht (8) angeordnet ist, dass das erste Ende der elektrisch isolierenden Schicht (7), das erste Ende der zweiten leitenden Metallschicht (2) und ein Abschnitt der dritten leitenden Metallschicht (3) die erste Oberfläche (8A) der dielektrischen Schicht (8) berühren.

12. Quantendiode nach einem der Ansprüche 1-10, **dadurch gekennzeichnet, dass** die Quantendiode Folgendes umfasst:
o eine dielektrische Schicht (8), umfassend eine erste Oberfläche (8A), und
o eine weitere leitende Metallschicht (6), die zwischen der ersten leitenden Metallschicht (1) und der dielektrischen Schicht (8) angeordnet ist, wobei die weitere Metallschicht (6) aus einem weiteren metallischen Material gefertigt ist, das sich von dem ersten metallischen Material der ersten leitenden Metallschicht (1) unterscheidet, dass die weitere leitende Metallschicht (6) eine erste Oberfläche (6A) und eine zweite Oberfläche (6B) gegenüber der ersten Oberfläche (6A) aufweist, wobei die erste Oberfläche (6A) mindestens einen Abschnitt der zweiten Oberfläche der ersten leitenden Metallschicht (1) sowie das erste Ende der elektrisch isolierenden Schicht (7), das erste Ende der zweiten leitenden Metallschicht (2) und einen Abschnitt der dritten leitenden Metallschicht (3) berührt, und die zweite Oberfläche (6B) die erste Oberfläche (8A) der dielektrischen Schicht (8) zumindest teilweise berührt.

13. Quantendiode nach dem vorherigen Anspruch, **dadurch gekennzeichnet, dass** die weitere leitende Metallschicht (6) aus Chrom gefertigt ist.

14. Quantendiode nach Anspruch 12 oder 13, **dadurch gekennzeichnet, dass** die weitere leitende Metallschicht (6) eine Stärke zwischen 10 nm und 30 nm, vorzugsweise 10 nm, aufweist.

## Revendications

1. Diode quantique pour transformer un courant alternatif, en particulier un courant alternatif à haute fréquence, en un courant continu, comprenant:
o une première couche métallique conductrice (1), où ladite première couche métallique conductrice (1) se comporte comme une première électrode ou cathode de ladite diode quantique et comprend une première surface (1A) et une deuxième surface (1B), opposée à la première surface (1A), une troisième surface (1C) joignant ladite première surface (1A) et ladite deuxième surface (1B), où ladite troisième surface (1C) entre en contact avec ladite première surface (1A) au niveau d'une première ligne de contact (L1) de telle manière que ladite troisième surface (1C) et ladite première surface (1A) forment un premier angle (α) supérieur ou égal à 90° et inférieur à 180°,
∘ une couche électriquement isolante (7) présentant une première extrémité et une deuxième extrémité et comprenant une première partie (71) et une deuxième partie (72), où ladite première partie (71) entre au moins partiellement en contact avec ladite troisième surface (1C) de ladite première couche métallique conductrice (1) et est parallèle à ladite troisième surface (1C), et ladite deuxième partie (72) est en contact avec une partie de la première surface (1A) de ladite première couche métallique conductrice (1) et est parallèle à ladite partie de ladite première surface (1A), ladite première partie (71) et ladite deuxième partie (72) sont agencées de manière à former un angle égal audit premier angle (α),
∘ une deuxième couche métallique conductrice (2) présentant une première extrémité et une deuxième extrémité et comprenant une première partie (21) et une deuxième partie (22), où ladite première partie (21) entre en contact avec la première partie (71) de ladite couche électriquement isolante (7) et est parallèle à ladite première partie (71), et ladite deuxième partie (22) est au moins partiellement en contact avec la deuxième partie (72) de ladite couche électriquement isolante (7) et est parallèle à ladite deuxième partie (72), ladite première partie (21) et ladite deuxième partie (22) sont agencées de manière à former un angle égal audit premier angle (α),
o une troisième couche métallique conductrice (3) se comportant comme une deuxième électrode ou anode, ladite troisième couche métallique conductrice (3) étant au moins partiellement en contact avec la première partie (21) et la deuxième partie (22) de ladite deuxième couche métallique conductrice (2) et est isolée électriquement de ladite première couche métallique conductrice (1), où ladite première couche métallique conductrice (1) est constituée d'un premier matériau métallique, ladite deuxième couche métallique conductrice (2) est constituée d'un deuxième matériau métallique, différent dudit premier matériau métallique, ladite première couche métallique conductrice (1) et ladite deuxième couche métallique conductrice (2) sont séparées par ladite couche électriquement isolante (7) et l'épaisseur de ladite couche électriquement isolante (7) est comprise entre 1,5 nm et 5 nm, de sorte que, lors de l'utilisation, une quantité d'électrons se déplace de ladite première couche métallique conductrice (1) vers ladite deuxième couche métallique conductrice (2), sautant, par effet tunnel, ladite couche électriquement isolante (7) au niveau de ladite première ligne de contact (L1).

2. Diode quantique selon la revendication précédente, **caractérisée en ce que** ladite première couche métallique conductrice (1) est constituée d'or.

3. Diode quantique selon l'une quelconque des revendications précédentes, **caractérisée en ce que** ladite deuxième couche métallique conductrice (2) est constituée de chrome.

4. Diode quantique selon l'une quelconque des revendications précédentes, **caractérisée en ce que** ladite première couche métallique conductrice (1) et ladite troisième couche métallique conductrice (3) sont constituées du même matériau métallique.

5. Diode quantique selon l'une quelconque des revendications précédentes, **caractérisée en ce que** ladite première couche métallique conductrice (1) a une épaisseur supérieure à l'épaisseur de ladite deuxième couche métallique conductrice (2).

6. Diode quantique selon l'une quelconque des revendications précédentes, **caractérisée en ce que** ladite première couche métallique conductrice (1) a une épaisseur entre 50 nm et 100 nm, de préférence 50 nm.

7. Diode quantique selon l'une quelconque des revendications précédentes, **caractérisée en ce que** ladite deuxième couche métallique conductrice (2) a une épaisseur entre 10 nm et 30 nm, de préférence 10 nm.

8. Diode quantique selon l'une quelconque des revendications précédentes, **caractérisée en ce que** ladite troisième couche métallique conductrice (3) a une épaisseur entre 50 nm et 100 nm, de préférence 50 nm.

9. Diode quantique selon l'une quelconque des revendications précédentes, **caractérisée en ce que** ladite couche électriquement isolante (7) est constituée de trioxyde de dialuminium ou de dioxyde d'hafnium ou de gallium.

10. Diode quantique selon l'une quelconque des revendications précédentes, **caractérisée en ce que** ladite troisième couche métallique conductrice (3) comprend:
- une première partie (31),
- une deuxième partie (32),
où ladite première partie (31) est au moins partiellement en contact avec la première partie (21) de ladite deuxième couche métallique conductrice (2) et est parallèle à ladite première partie (21), et ladite deuxième partie (32) est au moins partiellement en contact avec la deuxième partie (22) de ladite deuxième couche métallique conductrice (2) et est parallèle à ladite deuxième partie (22), ladite première partie (31) et ladite deuxième partie (32) sont agencées de manière à former un angle égal audit premier angle (α).

11. Diode quantique selon l'une quelconque des revendications 1-10, **caractérisée en ce que** ladite diode quantique comprend:
o une couche diélectrique (8) comprenant une première surface (8A), **en ce que** ladite première couche métallique conductrice (1) est agencée sur une partie de la première surface (8A) de ladite première couche diélectrique (8), **en ce que** la première extrémité de ladite couche électriquement isolante (7), la première extrémité de ladite deuxième couche métallique conductrice (2) et une partie de ladite troisième couche métallique conductrice (3) entrent en contact avec ladite première surface (8A) de ladite couche diélectrique (8).

12. Diode quantique selon l'une quelconque des revendications 1-10, **caractérisée en ce que** ladite diode quantique comprend:
o une couche diélectrique (8) comprenant une première surface (8A), et
∘ une couche métallique conductrice supplémentaire (6), agencée entre ladite première couche métallique conductrice (1) et ladite couche diélectrique (8), où ladite couche métallique supplémentaire (6) est constituée d'un matériau métallique supplémentaire, différent du premier matériau métallique de ladite première couche métallique conductrice (1), **en ce que** ladite couche métallique conductrice supplémentaire (6) comprend une première surface (6A) et une deuxième surface (6B), opposée à ladite première surface (6A), où ladite première surface (6A) est en contact avec au moins une partie de la deuxième surface de ladite première couche métallique conductrice (1), ainsi qu'avec la première extrémité de ladite couche électriquement isolante (7), la première extrémité de ladite deuxième couche métallique conductrice (2) et une partie de la troisième couche métallique conductrice (3), et ladite deuxième surface (6B) est au moins partiellement en contact avec la première surface (8A) de ladite couche diélectrique (8).

13. Diode quantique selon la revendication précédente, **caractérisée en ce que** ladite couche métallique conductrice supplémentaire (6) est constituée de chrome.

14. Diode quantique selon la revendication 12 ou 13, **caractérisée en ce que** ladite couche métallique conductrice supplémentaire (6) a une épaisseur entre 10 nm et 30 nm, de préférence 10 nm.
